# EUROPEAN PATENT APPLICATION

(11) **EP 2 660 975 A1**
(43) Date of publication of application: **06.11.2013**
(21) Application number: 13166265.2
(22) Date of filing: 02.05.2013
(51) Int. Cl.: H03F 3/24, H04B 1/00, H01Q 21/30

(54) **Tower mounted amplifier and method of use thereof**

(30) Priority: 04.05.2012 GB 201207856
(71) Applicant: Radio Design Limited, West Yorkshire BD17 7DW (GB)
(72) Inventor: Gostling, Martin, West Yorkshire, BD17 7DW (GB); Hickling, Paul, West Yorkshire, BD17 7DW (GB); Poppleton, David, West Yorkshire, BD17 7DW (GB)
(74) Representative: Tomkinson, Alexandra

(57) **Abstract**

A tower mounted amplifier is provided including a first receive section capable of receiving one or more radio frequency signals substantially in a first frequency band and the same receive section or at least a second receive section capable of receiving one or more radio frequency signals in at least a second frequency band. The tower mounted amplifier further includes one or more transmit sections capable of transmitting one or more radio frequency signals substantially in said first and/or at least second frequency bands. A single amplification means is provided in or associated with the first receive section or the first and at least second receive sections for amplifying one or more radio frequency signals in both said first and at least second frequency bands.

## Description

This invention relates to a tower mounted amplifier (hereinafter referred to as a TMA) and a method of use thereof.

A wireless communication network typically includes a plurality of cell sites which allow radio frequency signals to be transmitted to and received from mobile phone units. Each cell site typically includes a mast, at the top of which is typically mounted an antenna for transmitting and/or receiving one or more radio frequency signals and optionally a tower mounted amplifier (TMA) for amplifying the radio frequency signals. A base transceiver station (BTS) is typically located at the base of the mast and is connected via a feeder cable to the TMA. The BTS typically includes a transceiver that generates one or more radio frequency signals for transmission to a mobile phone unit, as well as receiving one or more radio frequency signals from the mobile phone unit.

There is a requirement for modern commercial wireless communication networks to provide high data rate connections to end users to support services such as video calling, internet browsing and multimedia downloading. The wireless connection between a cell site and a mobile phone unit is often the part of the network under most strain.

Historically, the wireless connections between a cell site and a mobile phone unit have been made using two or three frequency bands per region. For example, in the UK these frequency bands are at 900MHz, 1800MHz and 2100MHz. Each frequency band has also conventionally been assigned to a particular technology; the 900MHz and 1800MHz bands have typically been licensed for second generation (2G) system use only, and the 2100MHz band has been licensed for third generation (3G) system use. As 3G systems support higher data rates than 2G systems, the licenses for frequency bands previously restricted to 2G systems only have now been amended to allow 3G systems and potentially fourth generation (4G) systems to be deployed within them. In addition, further bandwidth is being made available via freeing up additional frequency bands. For example, spectrum freed up by the move from analogue to digital television has created an available frequency band within Europe at 800MHz. Mobile communication operators therefore need to invest significant amounts of money in their networks to provide the latest technologies in multiple bands whilst continuing to support legacy technology/band combinations. Consequently, mobile communication operators are under pressure to reduce capital expenditure (CAPEX) and operating expenditure (OPEX) wherever possible in their wireless communication networks.

A significant opportunity for cost saving for a mobile communication operator is sharing of network infrastructure. A single operator can share infrastructure between equipment operating in different bands.

Typically, a BTS at a cell site is needed for each frequency band, each operator and each technology. A common cell site configuration comprises splitting the area to be covered by the wireless communications network into three 120 degree sectors, with each sector serviced by an antenna configuration that provides a pair of statistically independent reception and/or transmission paths to the mobile phone units. There are several methods for producing such an antenna configuration including spatial diversity and X-polarised antennas. The feeder cables, TMAs and antennae are often referred to as an antenna system. In all cases the antenna systems will have a pair of ports, each port associated with one of the statistically independent paths. Within each sector the cell site may transmit on one or both antenna ports but it will receive on both. The use of two statistically independent paths for receiving a signal is referred to as receive diversity and improves the sensitivity of the BTS receiver. Receiver sensitivity directly impacts the cell site coverage and capacity. The impact that each component of the cell site has on receiver sensitivity can be understood by knowing how they impact the signal to noise ratio (SNR) of the received signal. The factor that the component decreases the SNR by is known as the noise figure (NF) of the component. The larger the NF of the component the more it degrades receiver sensitivity. The cables that connect the antenna to the transceiver decrease the SNR and operators seek to minimise this performance degradation by inserting a TMA at the top of the mast. The TMA contains a low noise amplifier (LNA) that is characterised by amplifying the desired signal whilst maintaining a low NF.

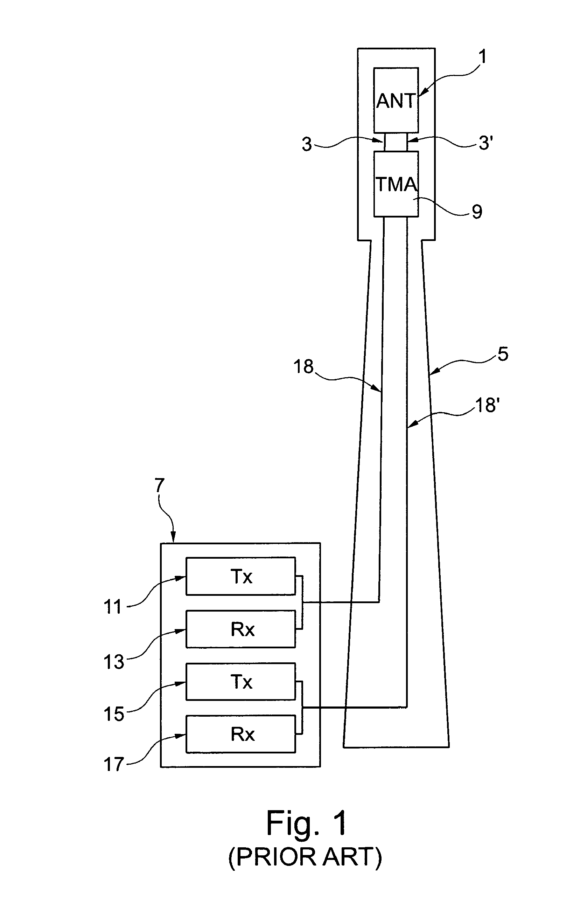

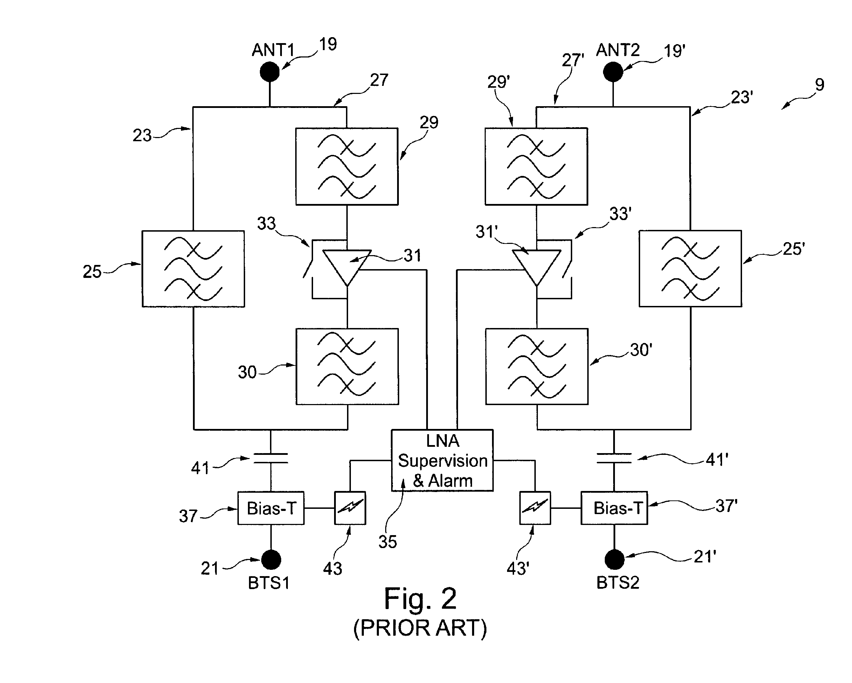

An example of a conventional cell site arrangement for a wireless communication network is illustrated with reference to figures 1 and 2. The cell site arrangement shown in figure 1 incorporates a single antenna 1 and a single base transceiver station (BTS) 7. The antenna 1 is mounted at the top of a mast 5 and has two ports, each of which is connected via cables 3, 3' to a tower mounted amplifier (TMA) 9 also located at the top of mast 5. The transceiver or BTS 7 is located at the base of the mast 5 and includes a first transmitter 11, a first receiver 13, a second transmitter 15 and a second receiver 17. The first transmitter 11 and first receiver 13 are connected via cable 18 to the TMA 9. The second transmitter 15 and the second receiver 17 are connected to the TMA 9 via cable 18'.

A simplified arrangement of the circuitry provided in the TMA 9 is shown in figure 2. The TMA has a pair of input/output ports 19, 19' that are connected to antenna 1 via feeder cables 3, 3' respectively, and a pair of input/output ports 21, 21' that are connected to the first transmitter 11 and first receiver 13 in BTS 7 via feeder cable 18 and to second transmitter 15 and second receiver 17 in BTS 7 via feeder cable 18'.

First and second transmit paths 23, 23' are provided in the apparatus for the transmission of one or more radio frequency transmit signals from the first and second transmitters 11, 15 to antenna 1. A transmit filter 25, 25' is located in each transmit path 23, 23' for filtering one or more transmit signals. In the illustrated example, the transmit filters 25, 25' are 2100 MHz transmit bandpass filters (i.e. they allow the passage of one or more transmit radio frequency signals in the 2100 MHz transmit frequency band but substantially stop the passage of radio frequency signals outside of this frequency band). The first and second transmit paths 23, 23' are provided between the input/output ports 19, 21 and 19'/21' of the TMA respectively.

Receive paths 27, 27' are provided in the TMA 9 for receiving one or more radio frequency receiver signals from antenna 1. First and second receive filters 29, 30; 29', 30' are provided in series in the receive paths 27, 27' respectively for filtering one or more receive signals. In the illustrated example, the receive filters 29, 30, 29', 30' are 2100MHz receive bandpass filters (i.e. they allow the passage of one or more receive radio frequency signals in the 2100MHz receive frequency band but substantially stop the passage of radio frequency signals outside of this frequency band). The first and second receive paths 27, 27' are provided between the input/output ports 19, 21 and 19'/21' of the TMA respectively. A low noise amplifier (LNA) 31, 31' is located between first and second receiver filters 29, 30, 29' 30' respectively for amplifying one or more receive signals. An amplifier bypass path 33, 33' is provided between the first and second filters 29, 30, 29', 30' in each receive path 27, 27' to allow one or more receive signals to bypass the LNA in the event of failure of or loss of power to the LNA. Each LNA 31, 31' is provided with LNA supervision and an alarm 35 to signal failure or power loss to the LNA. A bias-tee 37, 37' is provided adjacent input/output ports 21, 21' to direct a DC power supply to the LNAs 31, 31' in each receive path 27, 27' without substantially effecting the transmit or receive signals. A capacitor 41, 41' is provided between the second receiver filter 30, 30' and the bias-tee 37, 37' to act as a DC block to prevent DC current from entering the receive or transmit paths 23, 27, 23', 27' respectively. Lightning strike protection circuitry 43, 43' is provided between the bias-tee and the LNA supervision and alarm 35.

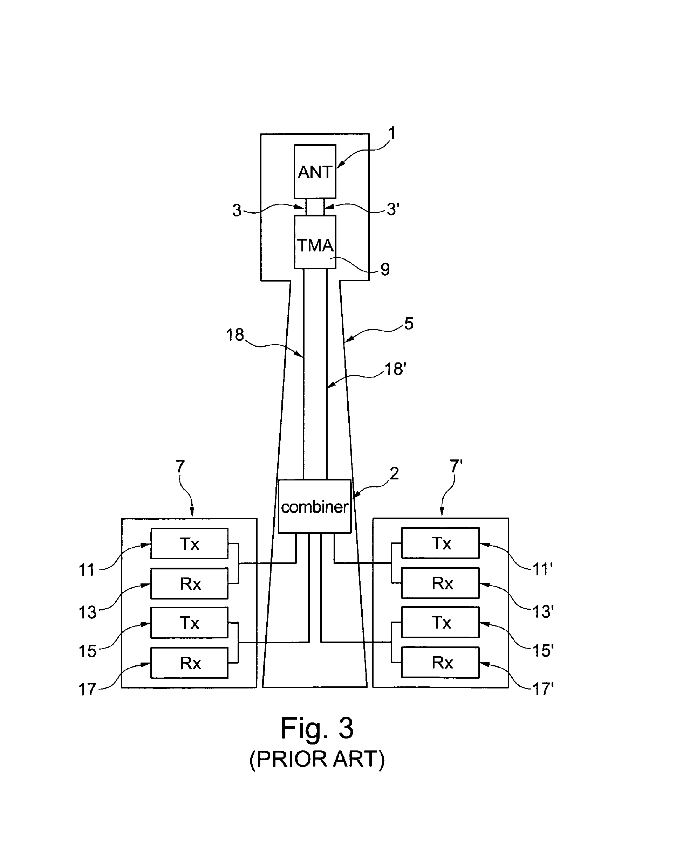

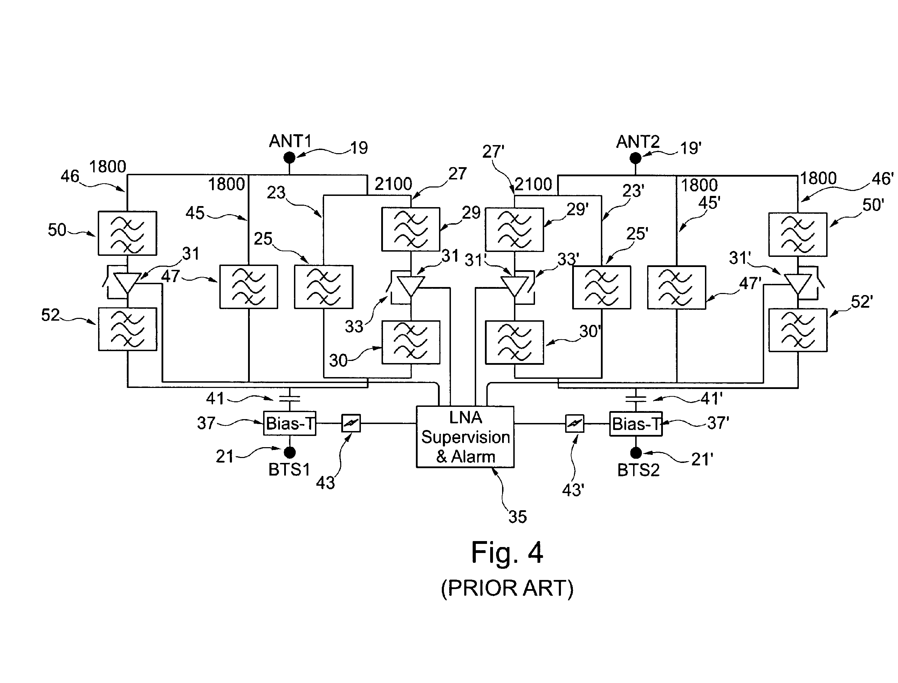

An example of a further conventional cell site arrangement for a wireless communication network is illustrated with reference to figures 3 and 4. The cell site arrangement shown in figure 3 allows a pair of BTSs operating in different frequency bands (i.e. 1800 MHz and 2100 MHz) to share a mast and antenna system, thereby reducing OPEX and CAPEX for the operator. As with the first illustrated prior art example, the cell site arrangement incorporates a single antenna 1 but includes two base transceiver stations (BTS) 7, 7'. BTS 7 operates in the 2100 MHz frequency band and BTS 7' operates in the 1800 MHz frequency band. The antenna 1 is mounted at the top of a mast 5 and has two ports, each of which is connected via cables 3, 3' to tower mounted amplifier (TMA) 9 also located at the top of mast 5. The transceiver or BTSs 7, 7' are located at the base of the mast 5 and include a first transmitter 11 11', a first receiver 13, 13', a second transmitter 15, 15' and a second receiver 17, 17'. A combiner 2 is provided between the BTSs 7, 7' and the TMA 9 to combine the radio frequency signals associated with the first transmitter and receivers 11, 13, 11', 13' onto cable 18 and to combine the radio frequency signals associated with the second transmitter and receivers 15, 17, 15', 17' onto cable 18'.

A simplified arrangement of the circuitry provided in the TMA 9 in figure 3 is shown in figure 4. As previously described, the TMA 9 has a pair of input/output ports 19, 19' that are connected to antenna 1 via feeder cables 3, 3' respectively, and a pair of input/output ports 21, 21' that are connected to combiner 2 via feeder cables 18, 18'. The transmit and receive paths 23, 27 and 23', 27' for the 2100MHz frequency band are as previously described. Transmit and receive paths 45, 46 and 45', 46' are provided between input/output ports 19, 21 and 19', 21' for the passage of the transmit and receive frequency signals in the 1800MHz frequency band. A transmit passband filter 47, 47' is provided in each of the transmit paths 45, 45' and receive passband filters 50, 52, 50', 52' are provided in each of the receive paths 46, 46' to allow the passage of the transmit and receive frequency signals in the 1800MHz transmit and receive frequency band and to prevent passage of frequency signals in other frequency bands. This is in addition to the transmit passband filters 25, 25' provided in the transmit path 23, 23'.

A problem with the arrangements shown in both figures 2 and 4 is that each receive path requires a separate LNA for amplifying the desired signal. This is expensive and increases the complexity of the circuitry within the TMA.

It is therefore an aim of the present invention to provide a tower mounted amplifier (TMA) which overcomes the abovementioned problem.

It is a further aim of the present invention to provide a method of using a tower mounted amplifier (TMA) which overcomes the abovementioned problem.

According to an aspect of the present invention there is provided a tower mounted amplifier, said tower mounted amplifier including a first receive section capable of receiving one or more radio frequency signals substantially in a first frequency band and the same receive section or at least a second receive section capable of receiving one or more radio frequency signals in at least a second frequency band, said tower mounted amplifier further including one or more transmit sections capable of transmitting one or more radio frequency signals substantially in said first and/or said at least second frequency bands, **characterised in that** a single amplification means is provided in or associated with the first receive section or the first and at least second receive sections for amplifying one or more radio frequency signals in both said first and at least second frequency bands.

Thus, by providing the present invention with one amplification means operable within the receive passband of at least two receive frequency bands, this reduces the costs and complexity associated with manufacturing the TMA. In sharing a single amplification means between the two different receive frequency bands, the present invention can reduce the number of amplifications means required in the TMA compared to conventional TMAs.

In one embodiment the TMA is provided with a first receive section that is capable of receiving one or more radio frequency signals in a first frequency band and at least a second frequency band. The receive pass bands of the first and at least second frequency bands can be directly adjacent to each other in the spectrum. In addition, or alternatively, the transmit pass bands of the first and second frequency bands do not lie between the receive bands of the first and second frequency bands. For example, the first and at least second frequency bands are at 800MHz and 900MHz respectively. In this embodiment a single amplification means is provided in the first receive section operable over both the first and at least second frequency bands.

In an alternative embodiment the TMA is provided with a first receive section and at least a second receive section, the first receive section for receiving one or more radio frequency signals in a first frequency band and the at least second receive section for receiving one or more radio frequency signals in at least a second frequency band. In this embodiment a single amplification means is shared between the first and second receive sections and is operable over both the first and at least second frequency bands. For example, the first and at least second frequency bands are at 1800MHz and 2100MHz. This arrangement is typically, but not necessarily exclusively employed when the transmit band of either or both frequency bands lies between the receive bands of the first and second frequency bands.

Thus, according to a further aspect of the present invention there is provided a tower mounted amplifier, said tower mounted amplifier including a first receive section for receiving one or more radio frequency signals substantially in at least a first frequency band and at least a second receive section for receiving one or more radio frequency signals substantially in at least a second frequency band, said tower mounted amplifier further including at least one transmit section for transmitting one or more radio frequency signals substantially in said first and/or said at least second frequency bands, **characterised in that** one amplification means is shared between the first and at least second receive sections for amplifying one or more signals in said first and said at least second frequency bands.

Preferably in either of the above described embodiments the TMA includes a first transmit section for transmitting one or more signals at the first frequency band and a second transmit section for transmitting one or more signals at the at least second frequency band.

Preferably a receive filter means is provided upstream of the amplification means in the one or more receive sections for allowing the passage of one or more receive radio frequency signals therethrough. The upstream receive filter means is operable at the same frequency band or bands as the receive section is operable at.

Preferably a receive filter means is provided downstream of the amplification means in the one or more receive sections for allowing passage of one or more receive radio frequency signals therethrough. The downstream receive filter means is operable at the same frequency band or bands as the receive sections is operable at.

Preferably the or each receive section includes both an upstream receive filter means and a downstream receive filter means. The two receive filter means are preferably provided in series in the receive section.

Preferably the receive filter means are bandpass filter means operable at the first and/or at least second frequency bands (i.e. it allows one or more radio frequency signals at the first and/or at least second frequency bands to pass therethrough but substantially prevents one or more frequency signals at a different frequency band to pass therethrough).

Each of the first and at least second frequency bands typically has a transmit frequency band and a receive frequency band. Thus, for example, the first frequency band has a transmit frequency band at or within said first frequency and a receive frequency band at or within said first frequency. The at least second frequency band has a transmit frequency band at or within said at least second frequency band and a receive frequency band at or within said at least second frequency band.

For certain frequency bands, the receive frequency bands may be adjacent to each other in the spectrum or the transmit bands of the first and second frequency bands may not lie between the receive bands of the first and second frequency bands and, in this arrangement, a TMA operable in frequency bands with adjacent receive frequency bands, such as at 800MHz and 900MHz, can be provided with a single receive section. For other frequency bands, where the receive frequency bands are non-adjacent to each other in the spectrum or the transmit band of either or both of the first and second frequency bands lies between the receive frequency bands of the first and second frequency bands, a TMA operable in frequency bands with non-adjacent receive frequency bands, such as 1800MHz and 2100MHz, are typically provided with at least two receive sections.

Preferably the at least second frequency band is substantially different to the at least first frequency band.

Preferably the one or more receive sections and the one or more transmit sections of the TMA are coupled to at least first antenna port means.

Preferably the at least first antenna port means is connectable directly or indirectly to at least a first antenna in use.

Preferably the one or more receive sections and the one or more transmit sections of the TMA are coupled to at least first BTS port means.

Preferably the at least first BTS port means is connectable directly or indirectly to at least a first BTS in use.

Preferably a transmit filter means is provided in the transmit section or each of the transmit sections of the TMA.

Preferably the transmit filter means is a bandpass filter operable at the frequency band of the transmit section (i.e. it allows one or more radio frequency transmit signals at the frequency band of the transmit section to pass therethrough but substantially prevents one or more frequency signals at a frequency band other than that of the transmit section).

Preferably the amplification means is any device which allows amplification or gain of an incoming signal. The amplification means could include one or a number of amplification stages within the same.

Preferably the amplification means is a low noise amplifier (LNA). A LNA is one which has a relatively small impact on the signal to noise ration of the incoming signal.

Bypass circuitry can be associated with the amplification means to allow the receive signal to bypass the amplification means in the event of failure of the amplification means or failure of a power supply to the amplification means.

Preferably the amplification means and/or the bypass circuitry is/are provided between first and second receive filter means in the first and/or second receive sections.

Alarm means and/or supervision means can be associated with the amplification means. The alarm means can be used to signal a fault associated with the amplification means to a suitable party.

In one embodiment the TMA is provided in a housing. The housing is preferably formed of such material and design to be substantially weatherproof to withstand external environmental conditions. The housing could be attached to, detachably attached to or integrally formed with an antenna with which the TMA is used.

In one embodiment the TMA is provided with mounting means for mounting it to a suitable support structure, such as for example, a mast, upright member, tower, suitable surface of a building and/or the like. The mounting means can include any or any combination of one or more brackets, nuts and bolts, screws, jubilee clips and/or the like.

A bandpass and/or receive filtering means is typically any suitable filtering means which allows frequency signals of the operating frequency or frequency band to pass through it but which substantially attenuates or prevents at least some other frequencies or frequency bands from passing through to a greater extent.

Preferably a bias tee is provided in the TMA. The bias tee directs a direct current (DC) power supply to the amplification means without substantially effecting transmit or receive signals.

Preferably capacitor means are associated with the bias tee. The capacitor means acts as a DC power block to substantially prevent DC current from entering the transmit or receive paths.

In one embodiment a wireless communication system includes two transceiver or base transceiver stations (BTSs), a mast and an antenna system. Preferably the antenna system supports transmission and/or reception of radio frequency signals via two statistically independent paths.

According to a further aspect of the present invention there is provided a method of using a tower mounted amplifier, said method including the steps of receiving one or more radio frequency signals substantially in a first frequency band via a first receive section, receiving one or more radio frequency signals in at least a second frequency band via the first receive section or at least a second receive section, transmitting one or more radio frequency signals substantially in said first and/or at least second frequency bands via one or more transmit sections, **characterised in that** a single amplification means is provided in or associated with the first receive section or the first and at least second receive sections for amplifying one or more radio frequency signals in both said first and at least second frequency bands.

According to further aspects of the present invention there are provided a cell site arrangement including a TMA and a method of use thereof.

According to yet further aspects of the present invention there are provided an antenna system including a TMA and a method of use thereof.

Detailed embodiments of the present invention will now be described with reference to the accompanying figures, wherein:
Figure 1 illustrates a prior art example of a typically cell site arrangement for a wireless communications network;
Figure 2 illustrates a simplified view of a prior art TMA for use in the conventional cell site arrangement of figure 1;
Figure 3 illustrates a further prior art example of a cell site arrangement for a wireless communications network;
Figure 4 illustrates a simplified view of a prior art TMA for use in the conventional cell site arrangement of figure 3;
Figure 5 is a simplified view of a TMA according to an embodiment of the present invention; and
Figure 6 is a simplified view of a TMA according to a further embodiment of the present invention.

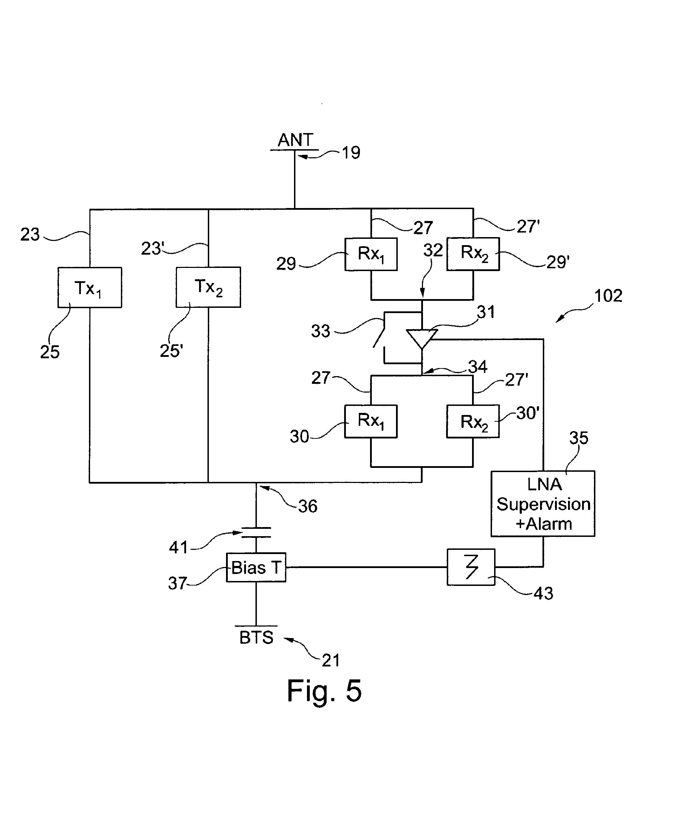

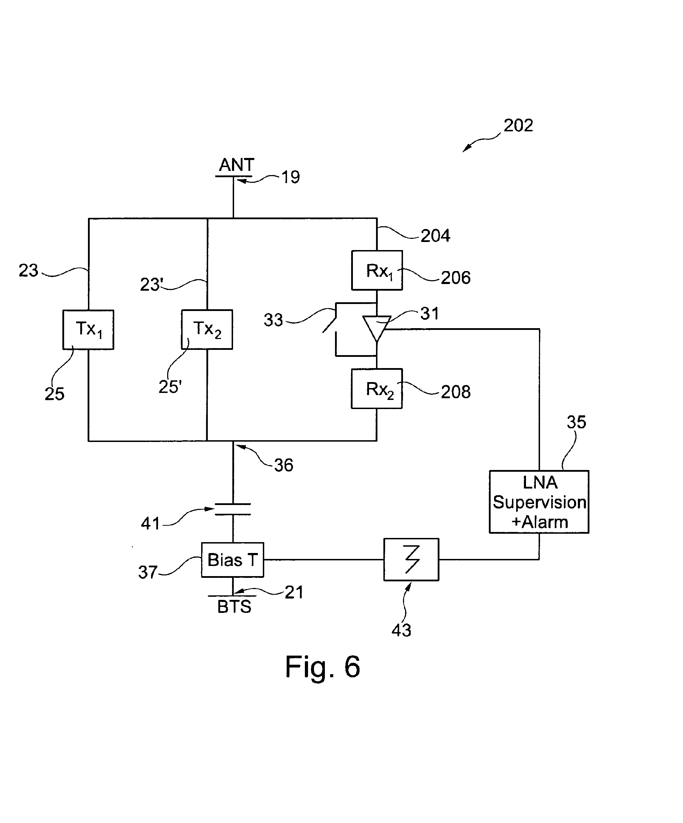

Referring to figures 5 and 6, there is illustrated a TMA for use in a cell site arrangement that allows two BTSs operating at different frequency bands to share a single antenna. According to the present invention the TMA uses a single LNA shared between two different receive frequency bands to reduce the cost and complexity of manufacturing the TMA.

The same reference numerals are used to describe the same features in the conventional arrangements in figures 1-4 as those shown in figures 5 and 6.

In one embodiment of the present invention as shown in figure 5, a TMA 102 is provided wherein a single LNA 31 is shared between two receive sections 27, 27'. Receive section 27 operates in a first receive frequency band of 2100MHz and receive section 27' operates in a second receive frequency band of 1800MHz. Each receive section 27, 27' includes a band pass receive filter 29, 29' located upstream of LNA 31. The receive sections 27, 27' are then multiplexed together at a point 32 downstream of the receive filters 29, 29' but upstream of the LNA to provide a single connection to LNA 31. The signal path downstream of the LNA 31 then splits back into the two receive sections 27, 27' at point 34 and a band pass receive filter 30, 30' is provided in each of said receive sections downstream of the LNA.

The band pass receive filters 29, 30 each allow one or more radio frequency receive signals within the 2100MHz frequency band to pass along receive section 27 but substantially prevents one or more radio frequency signals at any other frequency band to pass along the section. The band pass receive filters 29'. 30' each allow one or more radio frequency receive signals within the 1800MHz frequency band to pass along receive section 27' but substantially prevents one or more radio frequency signals at any other frequency band to pass along the section. The LNA 31 allows amplification or gain of incoming receive signals at both 1800MHz and 2100MHZ.

Transmit sections 23, 23' allow one or more radio frequency transmit signals in the frequency band 2100MHz and 1800MHZ respectively to pass along the same. Each transmit section 23, 23' is provided with a band pass transmit filter 25, 25'. Bandpass transmit filters 25, 25' allow one or more radio frequency transmit signals within the 2100MHz and 1800MHz respectively to pass along the section but substantially prevent one or more radio frequency signals at any other frequency band to pass along the section.

The transmit sections 23, 23' and receive sections 27, 27' are multiplexed together at a first end for connection to an antenna input/output port 19. This port 19 is then typically connected to an antenna 1 via feeder cables 3, 3' as in the prior art. The transmit sections 23, 23' and receive sections 27, 27' are multiplexed together at a second end for connection to a BTS input/output port 21.

An amplification bypass path 33 can be provided at either end of LNA 31 to allow one or more receive signals to bypass the LNA 31 in the event of failure of or loss of power to the LNA. The LNA is provided with LNA supervision and an alarm 35 to signal failure or power loss to the LNA. A bias tee 37 is provided adjacent input/output port 21 to direct a DC power supply to the LNA 31 without substantially effecting the receive signals. A capacitor 41 is provided between point 36 and the bias tee 37 to act as a DC block to prevent DC current from entering the receive or transmit paths 23, 23', 27, 27' respectively. Lightning strike protection circuitry 43 is provided between the bias tee 37 and the LNA supervision and alarm 35.

An example of a further embodiment of the present invention is shown in figure 6 with reference to TMA 202. In this embodiment, the TMA is operable over two different frequency bands but the frequency receive bands are either adjacent to each other in the spectrum or, alternatively, any one of the transmit band(s) do not fall within or between the different receive frequency bands, and therefore a single receive section 204 is provided which can operate in both frequency bands.

More particularly, receive section 204 can operate over receive frequency band 800MHz and 900MHz. A first band pass receive filter 206 is provided upstream of LNA 31 and a second band pass receive filter 208 is provided downstream of LNA 31. Each band pass receive filter 206, 208 allows one or more radio frequency receive signals within the 800MHz and 900MHz bands to pass along the section but substantially prevents one or more radio frequency signals at any other frequency band to pass along the section.

Transmit sections 23, 23' allow one or more radio frequency transmit signals in the frequency band 800MHz and 900MHZ respectively to pass along the same. Each transmit section 23, 23' is provided with a band pass transmit filter 25, 25'. Bandpass transmit filters 25, 25' allow one or more radio frequency transmit signals within the 800MHz and 900MHz respectively to pass along the section but substantially prevent one or more radio frequency signals at any other frequency band to pass along the section.

The transmit sections 23, 23' and receive section 204 are multiplexed together at a first end for connection to an antenna input/output port 19. This port 19 is then typically connected to an antenna 1 via feeder cables 3, 3' as in the prior art. The transmit sections 23, 23' and receive section 204 are multiplexed together at a second end for connection to a BTS input/output port 21 as previously described.

An amplification bypass path 33, LNA supervision and an alarm 35, bias tee 37, capacitor 41 and Lightning strike protection circuitry 43 are provided as previously described.

## Claims

1. A tower mounted amplifier, said tower mounted amplifier including a first receive section capable of receiving one or more radio frequency signals substantially in a first frequency band and the same receive section or at least a second receive section capable of receiving one or more radio frequency signals in at least a second frequency band, said tower mounted amplifier further including one or more transmit sections capable of transmitting one or more radio frequency signals substantially in said first and/or at least second frequency bands, **characterised in that** a single amplification means is provided in or associated with the first receive section or the first and at least second receive sections for amplifying one or more radio frequency signals in both said first and at least second frequency bands.

2. A tower mounted amplifier according to claim 1 **characterised in that** the first receive section is capable of receiving one or more radio frequency signals in a first frequency band and at least a second frequency band, the receive pass bands of the first and at least second frequency bands are either adjacent to each other in the spectrum or any one of the transmit frequency bands do not fall within or between the first receive frequency band and the at least second receive frequency band.

3. A tower mounted amplifier according to claim 1 **characterised in that** the first receive section is capable of receiving one or more radio frequency signals in a first frequency band and that at least a second receive section is capable of receiving one or more radio frequency signals in at least a second frequency band, the transmit frequency band of either or both the first and second frequency bands lies between the receive bands of the first and second frequency bands.

4. A tower mounted amplifier according to claim 1 **characterised in that** a first transmit section is provided for transmitting one or more signals at the first frequency band and a second transmit section for transmitting one or more signals at the at least second frequency band.

5. A tower mounted amplifier according to claim 1 **characterised in that** a receive filter means is provided upstream and/or downstream of the amplification means in the one or more receive sections for allowing the passage of one or more receive frequency signals therethrough.

6. A tower mounted amplifier according to claim 1 **characterised in that** an upstream and a downstream receive filter means is provided and said filter means are provided in series in the one or more receive sections.

7. A tower mounted amplifier according to claim 1 **characterised in that** transmit filter means are provided in the transmit section or each transmit section.

8. A tower mounted amplifier according to claim 1 **characterised in that** the amplification means is a low noise amplifier (LNA).

9. A tower mounted amplifier according to claim 1 **characterised in that** bypass circuitry is associated with the amplification means to allow one or more receive frequency signals to bypass the amplification means in the event of failure of the amplification means or failure of a power supply to the amplification means.

10. A tower mounted amplifier according to claim 1 **characterised in that** alarm means and/or supervision means are associated with the amplification means.

11. A tower mounted amplifier according to claim 1 **characterised in that** a bias tee is provided to direct a Direct Current (DC) power supply to the amplification means.

12. A tower mounted amplifier according to claim 11 **characterised in that** capacitor means are associated with the bias tee to act as a DC power block to substantially prevent DC current from entering the transmit or receive paths.

13. A tower mounted amplifier according to claim 1 **characterised in that** the one or more receive sections and the one or more transmit sections are coupled to at least first antenna port means, and said antenna port means is connectable directly or indirectly to at least a first antenna in use.

14. A tower mounted amplifier according to claim 1 **characterised in that** the one or more receive sections and the one or more transmit sections of the TMA are coupled to at least first base transceiver station (BTS) port means, and said at least first BTS port means is connectable directly or indirectly to at least a first BTS in use.

15. A method of using a tower mounted amplifier, said method including the steps of receiving one or more radio frequency signals substantially in a first frequency band via a first receive section, receiving one or more radio frequency signals in at least a second frequency band via the first receive section or at least a second receive section, transmitting one or more radio frequency signals substantially in said first and/or at least second frequency bands via one or more transmit sections, **characterised in that** a single amplification means is provided in or associated with the first receive section or the first and at least second receive sections for amplifying one or more radio frequency signals in both said first and at least second frequency bands.
